# EUROPEAN PATENT APPLICATION

(11) **EP 4 679 107 A1**
(43) Date of publication of application: **14.01.2026**
(21) Application number: 24188180.4
(22) Date of filing: 12.07.2024
(51) Int. Cl.: G01R 29/08

(54) **A METHOD AND APPARATUS FOR MEASURING A PERFORMANCE OF A MULTI-CHANNEL WAVEGUIDE ANTENNA MODULE**

(71) Applicant: Robert Bosch GmbH, 70442 Stuttgart (DE)
(72) Inventor: Ther, Istvan, 1103 Budapest (HU); Erdei, Bence, 2220 Vecses (HU)

(57) **Abstract**

A measurement apparatus (1) and a measurement method used for measuring a performance of a multi-channel waveguide antenna module (4) comprising a vector network analyser (2) having a first port (Port1) and a second port (Port 2) and comprising a connector positioner system (3) adapted to connect the first port (Port 1) of the vector network analyser (2) to an antenna element of the multi-channel waveguide antenna module (4) and to connect the second port (Port 2) of the vector network analyzer (2) to another antenna element of the waveguide antenna module (4), wherein the vector network analyzer (2) is adapted to measure a transmission signal indicating the power transmitted from the first port (Port 1) of the vector network analyser (2) to the second port (Port 2) of the vector network analyser (2) while an antenna element of the multi-channel waveguide antenna module (4) is radiating electromagnetic waves being reflected back by a corner reflector (5) of the measurement apparatus (1), wherein a time gating is applied to the measured transmission signal to isolate the signal reflection from the corner reflector (5) and to filter out unwanted reflections from surrounding surfaces, wherein the resulting frequency domain signal is processed by a processor of the vector network analyser (2) of the measurement apparatus (1) to provide performance parameters of the multi-channel waveguide antenna module (4).

## Description

### Technical Field

The invention relates to a method and apparatus for fast and accurate measurement of a performance of a multi-channel waveguide antenna module used in a radar sensor.

### Prior Art

Radar sensors for vehicles can be used to realize different functions, for example adaptive cruise control, and safety functions, for example used for an emergency braking system of the vehicle. Radar sensors are used for measuring physical variables directly rather than interpreting images, for example from a camera.

Radar sensors are adapted to transmit high-frequency radar beams and receive signals reflected from surrounding entities via an antenna structure. In this context, a detected entity in the surrounding of the vehicle may be stationary or moving. A distance and the direction (angle) relative to the detected entity can be calculated using the received radar beams. Radar sensor can be disposed in or on a vehicle, preferably a road vehicle, an aircraft, or a watercraft. The radar sensor can be suitable for partially autonomous or autonomous operation of the vehicle. US 2024036157A1 describes a radar sensor device and a method for self testing.

A waveguide antenna module is a metallized plastic or metal structure which contains a feed network and multiple radiating elements in one package. A waveguide antenna module can be used within a radar sensor. However, currently it is difficult and cumbersome to verify the performance a multi-channel the antenna module having a number of antenna elements with high accuracy on a wide angle range.

### Disclosure of the invention

The invention provides according to a first aspect a method for measuring a performance of a multi-channel waveguide antenna module comprising the steps of:
connecting a first port of a vector network analyser to an antenna element of the waveguide antenna module and connecting a second port of the vector network analyzer to another antenna element of the waveguide antenna module;
radiating an electromagnetic wave from an antenna element of the waveguide antenna module reflected back by a corner reflector;
measuring a transmission signal indicating the power transmitted from the first port of the vector network analyser to the second port of the vector network analyser; and
applying time gating to the measured transmission signal to isolate the signal reflection from the corner reflector and to filter out unwanted reflections from surrounding surfaces, wherein the resulting frequency domain signal is processed to provide performance parameters of the waveguide antenna module.

A vector network analyzer (VNA) is a measurement instrument adapted to measure S-parameters of multiport networks (transmission, reflection) in the frequency domain. The vector network analyzer is an instrument which can be used for analyzing passive and active components such as filters, amplifiers, mixers and multiport modules.

The network analyzers feature excellent RF characteristics and a wide variety of analysis functions that help the user evaluate important parameters at a glance. A waveguide antenna module is a metallized plastic or metal structure which contains a feed network and multiple radiating elements in one package. A waveguide is a closed metal structure which can conduct electromagnetic waves.

An antenna element of the waveguide antenna module is a device which is adapted to transform conducted electricity to free space wave propagation and vice versa. An antenna measurement is a process when the spatial emission of an antenna is measured with the use of measurement instruments.

The measurement method according to the present invention provides a small form factor, a high reproducibility and a fast measurement time.

The measurement method allows an easy and reproducible replacement of antenna modules as devices under test (DUT).

Further an automated measurement for all channel combinations of the multi-channel waveguide module can be performed.

The measurement method to the present invention provides a high stability over long term while having low maintenance needs.

The method provides in a possible embodiment a fully automated self-calibration thereby reducing the calibration time and calibration effort significantly.

In a possible embodiment of the method for measuring a performance of a multi-channel waveguide antenna module the frequency domain signal is processed to provide an antenna pattern for the antenna element of the waveguide antenna module.

In a possible embodiment of the method for measuring a performance of a multi-channel waveguide antenna module the frequency domain signal is processed to provide an antenna matching for the antenna element of the waveguide antenna module.

In a possible embodiment of the method for measuring a performance of a multi-channel waveguide antenna module the waveguide antenna module is mounted to plate of a first rotary stage of a rotary system and rotated around a surface normal of the plate to switch between an azimuth angle measurement with an adjustable azimuth angle and an elevation angle measurement with an adjustable elevation angle.This allows fast and easy testing of a waveguide antenna module over a wide range of possible angles.

In a possible embodiment of the method for measuring a performance of a multi-channel waveguide antenna module the waveguide antenna module is rotated by a second rotary stage of a rotary system along with the vector network analyser.

In a possible embodiment of the method for measuring a performance of a multi-channel waveguide antenna module all channel combinations of the multi-channel waveguide antenna module are measured automatically. This speeds up the measurement procedure and reduces the required measurement time for testing the multi-channel waveguide antenna module.

In a possible embodiment of the method for measuring a performance of a multi-channel waveguide antenna module the ports (Port1, Port 2) of vector network analyser are connected automatically by means of connectors of a connector positioner system to the antenna elements of the multi-channel waveguide antenna module. This also speeds up the measurement procedure and reduces the required measurement time for testing the multi-channel waveguide antenna module.

In a possible embodiment of the method for measuring a performance of a multi-channel waveguide antenna module the connectors of the connector positioner system are applied to the antenna elements of the multi-channel waveguide antenna modulewith a mating force for connection with the ports (Port1, Port 2) of the vector network analyser via flexible waveguides.This also accelerates the measurement procedure and reduces the required measurement time for testing the multi-channel waveguide antenna module.

The high frequency vector network analyzer has to be calibrated from time to time to ensure high accuracy measurements. The purpose of the calibration is mostly to compensate for channel transmission imperfections between the two (or multiple) ports of the vector network analyzer This increases the accuracy of the performed measurement significantly.

Different methods of calibration can be applied which all involve connecting specific standard components to the ports of the measuring line which will be connected to the device under test (DUT).

In a possible embodiment of the method for measuring a performance of a multi-channel waveguide antenna module an automated calibration of the vector network analyser is performed using calibration standard components.

In a possible embodiment of the method for measuring a performance of a multi-channel waveguide antenna module a connector positioner system is used to connect the calibration standard components during the automated calibration of the vector network analyser. This reduces the time required for calibration of the vector network analyser drastically.

In a possible embodiment of the method for measuring a performance of a multi-channel waveguide antenna module the calibration standard components comprise a short calibration standard component, an open calibration standard component, a through calibration standard component, a fixed match calibration standard component and a sliding match calibration standard component.

In a possible embodiment of the method for measuring a performance of a multi-channel waveguide antenna module the measurement of the measurement parameters of the multi-channel waveguide antenna module is performed in a frequency range between 60 to 90 GHz.

In a possible embodiment of the method for measuring a performance of a multi-channel waveguide antenna module the multi-channel waveguide antenna module comprises radar antenna elements. The radar antenna module can comprise an automotive multi-channel radar module used for a driver assistance system of a vehicle.

The invention further provides according to a second aspect a measurement apparatus or test system used for measuring a performance of a multi-channel waveguide antenna module. The measurement apparatus comprises a vector network analyser having a first port and a second port. The measurement apparatus further comprises a connector positioner system adapted to connect the first port of the vector network analyser to an antenna element of the multi-channel waveguide antenna module and to connect the second port of the vector network analyser to another antenna element of the waveguide antenna module. The vector network analyzer of the measurement apparatus is adapted to measure a transmission signal indicating the power transmitted from the first port of the vector network analyser to the second port of the vector network analyser (VNA). This can be performed while an antenna element of the multi-channel waveguide antenna module is radiating electromagnetic waves which is reflected back by a corner reflector of the measurement apparatus. Time gating is applied to the measured transmission signal to isolate the signal reflection from the corner reflector and to filter out unwanted reflections from surrounding surfaces. The resulting frequency domain signal is processed by a processor of the vector network analyser of the measurement apparatus to provide performance parameters of the multi-channel waveguide antenna module.

In a possible embodiment of the measurement apparatus a rotary system is provided having a first rotary stage and a second rotary stage, wherein the waveguide antenna module is mounted to plate of the first rotary stage of said rotary system and rotated around a surface normal of the plate to switch between an azimuth angle measurement with an adjustable azimuth angle and an elevation angle measurement with an adjustable elevation angle, and wherein the waveguide antenna module is rotated by the second rotary stage of said rotary system along with the vector network analyser of the measurement apparatus.

In a possible embodiment of the measurement apparatus an automated self-calibration system is provided.

### Detailed description

In the following possible embodiments of the method and apparatus according to the present invention are described in more detail with reference to the enclosed figures.
- Fig.1: shows a flowchart of a possible exemplary embodiment of the method for measuring a performance of a multi-channel waveguide antenna module according to a first aspect of the present invention;
- Fig.2: shows a block diagram of a possible exemplary embodiment of a measurement apparatus for measuring a performance of a multi-channel waveguide antenna module according to a second aspect of the present invention;
- Fig. 3: illustrates an exemplary possible implementation of a positioner system of a measurement apparatus for measuring a performance of a multi-channel waveguide antenna module;
- Fig. 4: illustrates exemplary standard calibration components used for self-calibration by the method and apparatus according to the present invention;
- Fig.5: illustrates exemplary motorized standard calibration component used for self-calibration by the method and apparatus according to the present invention;
- Fig.6: illustrates an exemplary multi-channel waveguide antenna module inside a radar sensor.

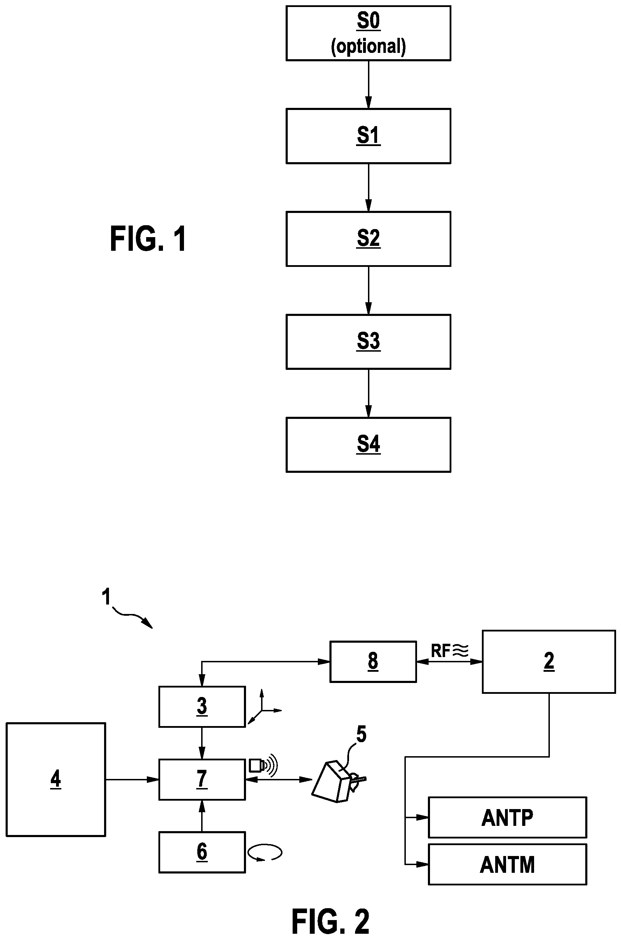

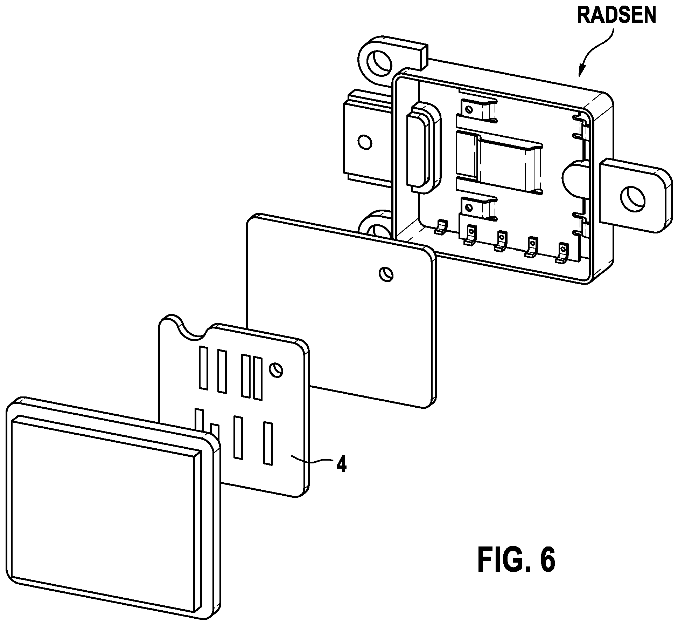

As illustrated in the flow chart of Fig.1 a method for measuring a performance of a multi-channel waveguide antenna module (WAM) comprises in a possible embodiment several main steps S1 to S4. The investigated waveguide antenna module 4 can form part of an automotive radar sensor RADSEN as illustrated in Fig 6.

Before the measurement method according to the present invention comprising steps S1 to S4 is initiated calibration steps of a calibration routine S0 may take place. The calibration routine can be performed in a preferrerd embodiment automatically by a calibration system without manual operation of a user.

The measurement method illustrated in Fig. 1 can be performed by a measurement program comprising program instructions adapted to perform steps S1 to S4. The measurement program can be loaded from a program memory and then be executed on a controller of the measurement device 1.

In a first step S1 of the measurement method a first port (Port1) of a vector network analyser (VNA) 2 of a measurement apparatus 1 as illustrated in the schematic diagram of Fig.2 is connected to an antenna element of the waveguide antenna module 4 and a second port (Port 2) of the vector network analyzer 2 is connected to another antenna element of the waveguide antenna module 4.

In a further step S2 an electromagnetic wave is radiated from an antenna element of the waveguide antenna module 4 and reflected back by a corner reflector 5 of the measurement apparatus 1. The antenna element of the waveguide antenna module 4 can be selected in response to a control signal.

In a further step S3 a transmission signal indicating the power transmitted from the first port (Port 1) of the vector network analyser 2 to the second port (Port 2) of the vector network analyser 2 is measured. The vector network analyser (VNA) 2 is adapted to measure the magnitude and phase of the scattering parameters (S-parameters) of each channel or antenna element combination, which are essential for understanding how signals behave as they pass through or reflect off components. A measured S21- transmission parameter indicates how much power passes through the respective channel.

In a further step S4 of the method time gating is applied to the measured transmission signal to isolate the signal reflection from the corner reflector 5 and to filter out unwanted reflections from surrounding surfaces. The resulting frequency domain signal is processed to provide performance parameters of the waveguide antenna module 4.

The time gating applied in step S4 of the method according to the present invention works comprises in a possible embodiment the following substeps: The corner reflector 5 is provided at a known distance from the measurement point in a setup of the measurement apparatus 1. This distance can be adjustable in possible implementation or fixed in an alternative implementation.

An S21 measurement is performed by the vector network analyser 2, which captures the transmitted signal over a range of frequencies and includes both the desired reflection from the corner reflector 5 and unwanted reflections from other objects. The measured stray parameter (S21) signal is initially in the frequency domain. To apply time gating, this signal is transformed to the time domain using an Inverse Fast Fourier Transform (IFFT).

In the time domain, different reflections appear at different times. The reflection from the corner reflector 5 at the predefined distance does appear at a specific time corresponding to the round-trip travel time of the radiated electromagnetic wave (since the wave travels to the reflector and back). A time gate is applied around the expected arrival time of the reflection from the corner reflector 5. For a corner reflector 5 being provided at a specific distance, the round-trip time RTT can be calculated using the speed of light. The time gate is typically centered at this time with a small time window. This applied time gating isolates the signal corresponding to the reflection from the corner reflector 5, effectively filtering out other reflections.

The time-gated signal is then transformed back to the frequency domain using a Fast Fourier Transform (FFT).The resulting frequency-domain signal now primarily contains the information from the desired reflection, with minimal interference from other reflections.

In a possible embodiment of the method for measuring a performance of a multi-channel waveguide antenna module the frequency domain signal is processed by a processor of the vector network analyser 2 to provide an antenna pattern ANTP for the antenna element of the waveguide antenna module 4.

In a possible embodiment of the method for measuring a performance of a multi-channel waveguide antenna module the frequency domain signal is processed by a processor of the vector network analyser 2 to provide an antenna matching ANTP for the antenna element of the waveguide antenna module 4.

The antenna pattern ANTP and the antenna matching ANTP of a tested waveguide antenna module 4 can be output via a user interface as outputs of the vector network analyser 2 as illustrated in Fig.2. and/or stored in a data memory.

In a possible embodiment of the method for measuring a performance of a multi-channel waveguide antenna module the waveguide antenna module 4 is mounted to plate of an adapter board 7. A first rotary stage of a rotary system 6 can be used to rotate the plate around a surface normal of the plate to switch between an azimuth angle measurement with an adjustable azimuth angle and an elevation angle measurement with an adjustable elevation angle.

In a possible embodiment of the method for measuring a performance of a multi-channel waveguide antenna module the waveguide antenna module 4 can be rotated by a second rotary stage of the rotary system 6 of the measurement apparatus 1 along with the vector network analyser 2.

In a possible embodiment of the method for measuring a performance of a multi-channel waveguide antenna module all channel combinations of the multi-channel waveguide antenna module 4 are measured automatically under control of a controller of the measurement apparatus 1.

In a possible embodiment of the method for measuring a performance of a multi-channel waveguide antenna module the ports (Port1, Port 2) of vector network analyser 2 are connected automatically by means of connectors of a connector positioner system 3 to the antenna elements of the multi-channel waveguide antenna module 4. The connector positioner system 3 is controlled by the controller of the measurement apparatus 1 to perform automatically a measurement routine according to steps S1 to S4.

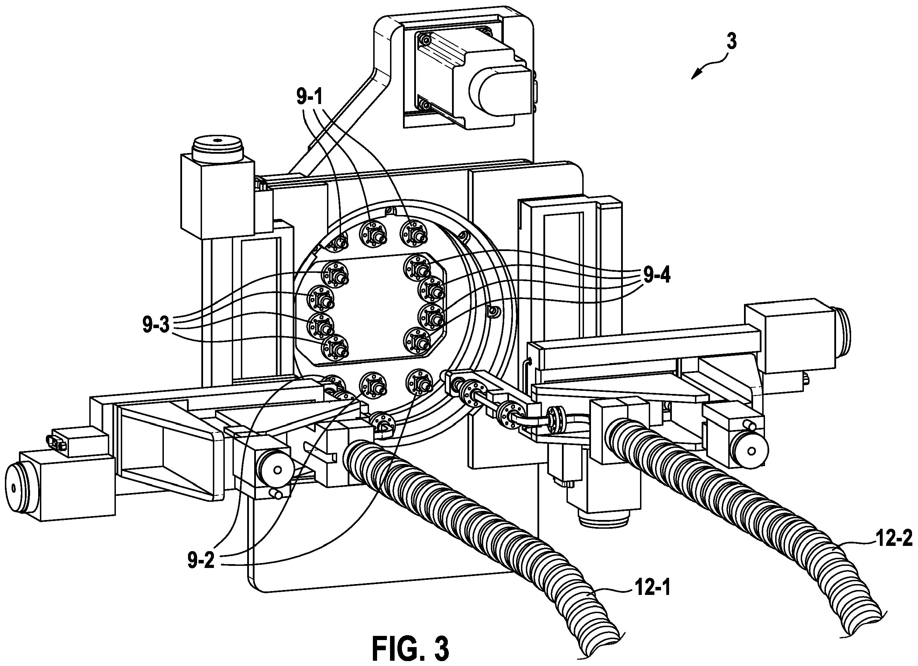

In a possible embodiment of the method for measuring a performance of the investigated or tested multi-channel waveguide antenna module 4 the connectors of the connector positioner system 3 are applied to the antenna elements of the multi-channel waveguide antenna module 4 with a mating force for connection with the ports (Port1, Port 2) of the vector network analyser 2 via flexible waveguides 12-1, 12-2 as also illustrated in Fig.3. Fig.3 shows a possible embodiment of a connector positioner system 3 of the measurement apparatus 1. The positioner system 3 shown in Fig.3 comprises ports 9-1, 9-2 for self-calibration and ports 9-3, 9-4 for module inputs of the waveguide antenna module 4.

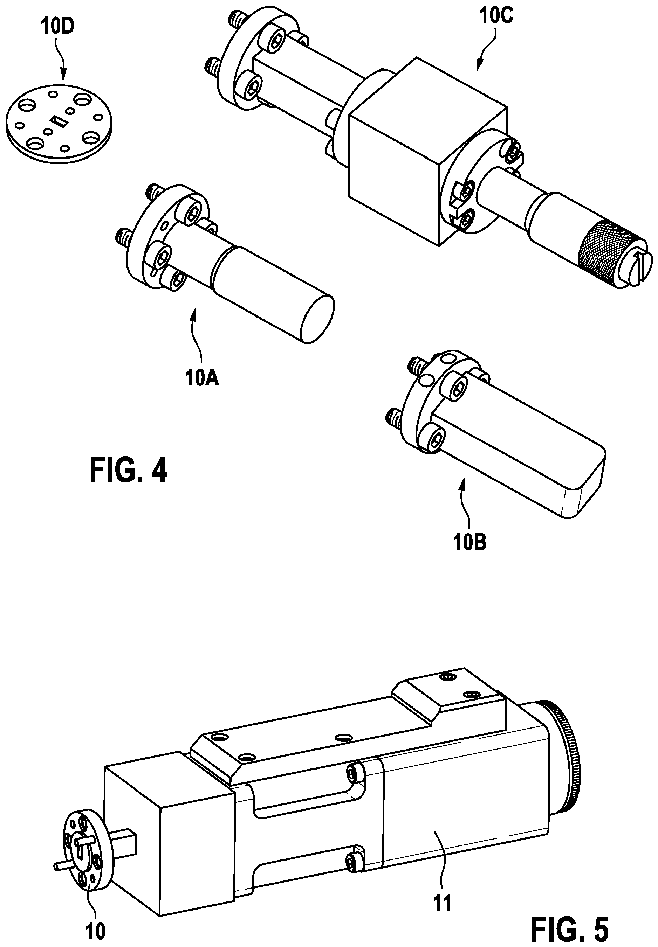

In a preferred embodiment of the method for measuring a performance of a multi-channel waveguide antenna module 4 an automated calibration of the vector network analyser 4 is performed in initial calibration routine S0 shown in the flowchart of Fig.1 using available calibration standard components 10 such as illustrated in Fig.4. The fully automated self-calibration can be performed in step S0 before the method illustrated in the flow chart of Fig.1 is initiated, i.e. before step S1.

Calibration may be performed in a possible embodiment each time the vector network analyser 2 is energized, exposed to environmental changes or has changes made to the test frequency(s) or test system, i.e. the associated jumpers, connectors/adapters and or couplers used to couple the DUT with the vector network analyser 2 of the measurement apparatus 1.

The vector network analyser 2 is calibrated in calibration step S0 by identifying and quantifying systemic errors present in the test system. Vector network analysers are generally designed for use with several different methods of calibration to account for the different forms of test system errors. Each calibration step removes one or more of the systematic errors through vector error correction. Vector error correction may characterize the systematic errors by measuring, for example, calibration standards (devices with known s-parameters) then mathematically removing the effects of the systematic errors from subsequent measurements on the device under test (DUT).

A method of calibration involves the alternate use of shorts, opens, loads, and a thru (direct connection of VNA test ports) using a known high precision standard in place of the DUT. This method may be time consuming and expensive, requiring a range of different standards and or adapters to approximate a range of desired DUTs. Further, each time the test system is assembled with a different standard or configuration, the interconnections between components may become worn or damaged, introducing further errors into the calibration. Also, the connections and reconnections themselves may cause erroneous calibrations due to variances in the torque, contact surface area, contact pressure and or alignment between the various connectors. In many cases, no standard similar to the DUT exists. Further, it may be impossible to connect available standards to each other, the vector network analyser and or the DUT. Accordingly the measurement apparatus 1 according to the present invention provides in a preferred embodiment a fully automated calibration of its vector network analyser 2.

The connector positioner system 3 can be used to connect calibration standard components 10 during the automated calibration of the vector network analyser 2. Conventional higher frequency calibration kits (~76GHz, used by automotive radars) always include manual work which is labour intensive and also prone to human assembly error. In contrast the measurement apparatus 1 comprises a connector positioner system 3 which can be controlled by a controller of the measurement apparatus 1 for performing an automated calibration in calibration routine S0. The calibration standard components 10 used during the automated calibration S0 can comprise a short calibration standard component, an open calibration standard component, a thru (trough)-calibration standard component, a fixed match calibration standard component and a sliding match calibration standard component.

Fig. 4 illustrates a possible implantation of a short calibration standard component 10A, a fixed match calibration standard component 10B, sliding match calibration standard component 10C and a spacer plate used to achieve an open calibration standard component 10D. Fig. 5 illustrates a possible exemplary implementation of a motorized calibration standard component 10A driven by a controlled motor 11.

The short calibration standard component 10 A shown in Fig. 4 provides a short circuit where the impedance is very low (close to zero). The vector network analyser 2 measures the response, which should ideally be low impedance (zero). This calibration step helps the vector network analyser 2 to characterize the residual capacitance of the measurement setup.

The load calibration standard component 10 B provides a fixed matched load, usually 50 ohms. Also an adjustable matched load forming the characteristic impedance of the investigated system can be provided by a sliding match calibration component 10C as illustrated in Fig 4. The vector network analyser 2 measures the response, which should ideally match the system's characteristic impedance. This calibration step helps the vector network analyser 2 to characterize the reflection coefficient for a matched load.

The open calibration standard component 10D shown in Fig. 4 provides an open circuit where no current flows and the impedance is very high. The vector network analyser 2 measures the response, which should ideally be high impedance (infinite).This calibration step helps the vector network analyser 2 to characterize the residual inductance of the measurement setup.

The Thru -calibration standard component provides a direct connection between the two ports of the vector network analyser 2 used to measure transmission characteristics. The vector network analyser 2 measures the response to determine the transmission characteristics. This calibration step helps the vector network analyser 2 to account for any losses or phase shifts in the connection.

The calibration of the vector network analyser 2 with open, short, load, and thru standards is necessary for accurate measurements. By using these known calibration standards, the vector network analyser 2 of the measurement apparatus 1 can correct for systematic errors in its measurement setup, ensuring reliable and precise characterization of RF and microwave components and systems.

The 3-axis positioner system 3 of the measurement apparatus 1 can also be used to connect the coaxial connectors and apply a suitable mating force to the calibration standard components 10 so that no human interaction becomes necessary. A TOSM principle can be used for the highest calibration accuracy with the following calibration standard components:
- Thru calibration standard component (known length section)
- Open calibration standard component (short + spacer)
- Short calibration standard component
- Fixed match calibration standard component
- Sliding match calibration standard component

In a preferred embodiment of the automated calibration system of the measurement apparatus 1 the sliding match calibration standard component 10 C is motorized as also shown in Fig.5. A precision stepper motor 11 can be used to move the sliding match calibration standard component 10C to the necessary position. In this way the full TOSM calibration can be performed in an automated way using the 3D positioner system 3 of the measurement apparatus 1. The automated calibration provides 100% automation in waveguide antenna testing (reflection, transmission). The driving motor or actuator 11 of the sliding match calibration standard component 10 C can be controlled in a preferred embodiment by a controller of a calibration system. This allows an automatic adjustment of a matching load under control of the controller of a calibration system.

In a possible embodiment of the method for measuring a performance of a multi-channel waveguide antenna module 4 the measurement of the measurement parameters of the multi-channel waveguide antenna module 4 is performed in a frequency range between 60 to 90 GHz.

In a possible embodiment of the method for measuring a performance of a multi-channel waveguide antenna module the multi-channel waveguide antenna module 4 comprises radar antenna elements of a radar sensor RADSEN as illustrated in Fig.6.

The invention further provides according to a second aspect a measurement apparatus 1 used for measuring a performance of a multi-channel waveguide antenna module 4 as illustrated schematically in the block diagram of Fig.2. The measurement apparatus 1 shown in Fig.2 comprises a vector network analyser (VNA) 2 having a first port (Port 1) and a second port (Port 2). The measurement apparatus 1 further comprises a connector positioner system 3 adapted to connect the first port (Port 1) of the vector network analyser 2 to an antenna element of the multi-channel waveguide antenna module (WAM) 4 as a device under test (DUT) and adapted to connect the second port (Port 2) of the vector network analyzer 2 to another antenna element of the waveguide antenna module 4. The connection via the microwave network 8 comprising waveguides for microwaves RF can be performed automatically.

The vector network analyser 2 of the measurement apparatus 1 is adapted to measure a transmission signal indicating the power transmitted from the first port (Port 1) of the vector network analyser 2 to the second port (Port 2) of the vector network analyser 2 while an antenna element of the multi-channel waveguide antenna module 4 is radiating electromagnetic waves which are reflected back by a corner reflector 5 of the measurement apparatus 1.

The corner reflector 5 is a device that reflects electromagnetic waves, such as radar signals, back towards the source. There are several types of corner reflectors 5, but they all share the same fundamental design principle. The corner reflector 5 consists in a possible implementation of three mutually perpendicular, intersecting flat surfaces (usually mirrors or metal plates), which form a corner. When the radiated electromagnetic wave hits this corner, it is reflected three times, one from each of the three surfaces, ultimately directing the wave back to its point of origin.

In a possible embodiment of the measurement apparatus 1 a rotary system 6 is provided having a first rotary stage and a second rotary stage. The waveguide antenna module (WAM) 4 as the device under test (DUT) can be mounted to a plate of an adapter board 7. A first rotary stage of the rotary system 6 can be controlled by a controller of the measurement apparatus 1 to rotate the plate round a surface normal of the plate to switch between an azimuth angle measurement with an adjustable azimuth angle and an elevation angle measurement with an adjustable elevation angle. The waveguide antenna module 4 can also be rotated by a second rotary stage of the rotary system 6 along with the vector network analyser 2. In a possible embodiment of the measurement apparatus 1 the apparatus comprises also an automated self-calibration system.

The measurement apparatus 1 provides a fully automated system which comprises in a possible embodiment as main components a two- port vector network analyzer (VNA) 2 with frequency extenders (60-90GHz), a first rotary stage of a rotary system 6 which is adapted to rotate the antenna module 4 around the surface normal to switch between azimuth and elevation measurement and a second rotary stage of the rotary system 6 which is adapted to rotate the full system with the two-port vector network analyzer (VNA) 2. The outputs of the vector network analyser 2 illustrated in the block diagram if Fig.2 are an antenna pattern ANTP (azimuth, elevation) and/or an antenna matching ANTM.

The measurement apparatus 1 can further comprise in a possible embodiment a 2 x 3 axis connector positioner system 3, two flexible waveguide sections, waveguide - coaxial transitions, quick connectors which do not need screw tightening. In a further embodiment of the measurement apparatus 1 a linear stage is provided which combined with another linear stage and a rotary stage allows to achieve a circular travel path.

A vector network analyser 2 can be used with two channels and with 60-90GHz frequency extenders. Port 1 is connected to one antenna, and port 2 is to another antenna in the module 4. A corner reflector 5 is used in a preferred embodiment as a target. To eliminate the need of absorber walls, time gating is used at the distance of the corner reflector (e.g. 1m).Time gating is applied on the measured transmission (S21) signal in step S4 and only the filtered range (e.g.1m ± 0.01m) is transformed back to the frequency domain. Because of the time gating, no anechoic chamber needed. This leads to a compact form factor. On the whole angular range of the measurement the system can be rotated and the measurements can be performed.

In a possible embodiment two-way antenna patterns are recorded, and out of the multiple measurements the single channel antenna diagrams can be calculated with post processing. The two-way antenna pattern effectively describes the overall efficiency and directivity of the antenna element of the multi-channel waveguide antenna module 4.

The radiation pattern of an antenna element describes how it radiates energy into space. It can typically be represented in polar or cartesian coordinates and shows the relative power radiated by the antenna element in different directions. The reception pattern of an antenna element describes how it receives energy from different directions. This pattern is often the same as the radiation pattern due to the principle of reciprocity, which states that the transmission and reception characteristics of an antenna are identical.

The two-way antenna pattern can be obtained by combining the transmission and reception patterns. This can be done by multiplying the gain of the antenna element in the transmission direction by the gain in the reception direction.

For provision of an automated connection the 3-axis positioner system 3 of the measurement apparatus 1 can be used to connect the coaxial connectors and apply a mating force. The provision of flexible waveguides allows the positioners to move freely. The whole plate where the antenna module 4 is mounted can be rotated for switching between elevation angle measurement or azimuth angle measurement. The coaxial connectors are used for utilizing the coaxial transmission mode which is not dependent on rotation around the axis.

The method and measurement apparatus 1 according to the present invention provide for an accurate gain and antenna pattern measurement and input matching measurement, in particular over a 72-82 GHz frequency range.

The method and measurement apparatus 1 according to the present invention provide in a possible embodiment for an angle measurement range of ±90° azimuth at 0° elevation, ±90° elevation at 0° azimuth and up to ±45° offset angles (for example ±90° azimuth at ±45° elevation).

Other advantages of the method and measurement apparatus 1 according to the present invention include a small form factor, a high reproducibility and a fast measurement time. The method and measurement apparatus 1 allow an easy and reproducible replacement of antenna modules 4 as devices under test (DUT). Further an automated measurement for all channel combinations of the multi-channel waveguide module 4 can be performed. The method and apparatus according to the present invention provide a high stability over long term while having low maintenance needs. The method and apparatus provide in a possible embodiment a fully automated self-calibration thereby reducing the calibration effort significantly.

The embodiments illustrated in Fig.1 to 6 can be combined eith each other.

## Claims

1. A method for measuring a performance of a multi-channel waveguide antenna module comprising the steps of:
connecting (S1) a first port (Port 1) of a vector network analyser (2) to an antenna element of the waveguide antenna module (4) and connecting a second port (Port 2) of the vector network analyzer (2) to another antenna element of the waveguide antenna module (4);
radiating (S2) an electromagnetic wave from an antenna element of the waveguide antenna module (4) reflected back by a corner reflector (5);
measuring (S3) a transmission signal indicating the power transmitted from the first port (Port1) of the vector network analyser (2) to the second port (Port 2) of the vector network analyser (2); and
applying time gating (S4) to the measured transmission signal to isolate the signal reflection from the corner reflector (5) and to filter out unwanted reflections from surrounding surfaces, wherein the resulting frequency domain signal is processed to provide performance parameters of the waveguide antenna module (4).

2. The method for measuring a performance of a multi-channel waveguide antenna module according to claim 1 wherein the frequency domain signal is processed to provide an antenna pattern (ANTP) for the antenna element of the waveguide antenna module (4).

3. The method for measuring a performance of a multi-channel waveguide antenna module according to claim 1 wherein the frequency domain signal is processed to provide an antenna matching (ANTM) for the antenna element of the waveguide antenna module (4).

4. The method for measuring a performance of a multi-channel waveguide antenna module according to any of the preceding claims 1 to 3 wherein the waveguide antenna module (4) is mounted to plate of a first rotary stage of a rotary system (6) and rotated around a surface normal of the plate to switch between an azimuth angle measurement with an adjustable azimuth angle and an elevation angle measurement with an adjustable elevation angle.

5. The method for measuring a performance of a multi-channel waveguide antenna module according to any of the preceding claims 1 to 4 wherein the waveguide antenna module (4) is rotated by a second rotary stage of a rotary system (6) along with the vector network analyser (2).

6. The method for measuring a performance of a multi-channel waveguide antenna module according to any of the preceding claims 1 to 5 wherein all channel combinations of the multi-channel waveguide antenna module (4) are measured automatically.

7. The method for measuring a performance of a multi-channel waveguide antenna module according to any of the preceding claims 1 to 6 wherein the ports (Port 1, Port 2) of vector network analyser (2) are connected automatically by means of connectors of a connector positioner system (3) to the antenna elements of the multi-channel waveguide antenna module (4).

8. The method for measuring a performance of a multi-channel waveguide antenna module according to claim 7 wherein the connectors of the connector positioner system (3) are applied to the antenna elements of the multi-channel waveguide antenna module (4) with a mating force for connection with the ports (Port 1, Port 2) of the vector network analyser (4) via flexible waveguides (12).

9. The method for measuring a performance of a multi-channel waveguide antenna module according to any of the preceding claims 1 to 8 wherein an automated calibration of the vector network analyser (VNA) is performed using calibration standard components (10).

10. The method for measuring a performance of a multi-channel waveguide antenna module according to claim 9 wherein a connector positioner system (3) is used to connect the calibration standard components (10) during the automated calibration of the vector network analyser (2).

11. The method for measuring a performance of a multi-channel waveguide antenna module according to claim 9 or 10 wherein the calibration standard components (10) comprise a short calibration standard component (10A), an open calibration standard component (10D), a thru-calibration standard component, a fixed match calibration standard component (10B) and a sliding match calibration standard component (10C).

12. The method for measuring a performance of a multi-channel waveguide antenna module according to any of the preceding claims 1 to 11 wherein the measurement of the measurement parameters of the multi-channel waveguide antenna module (4) is performed in a frequency range between 60 to 90 GHz.

13. The method for measuring a performance of a multi-channel waveguide antenna module according to any of the preceding claims 1 to 12 wherein the multi-channel waveguide antenna module (4) comprises radar antenna elements.

14. A measurement apparatus (1) used for measuring a performance of a multi-channel waveguide antenna module (4) comprising:
a vector network analyser (2) having a first port (Port 1) and a second port (Port 2); and
a connector positioner system (3) adapted to connect the first port (Port 1) of the vector network analyser (2) to an antenna element of the multi-channel waveguide antenna module (4) and to connect the second port (Port 2) of the vector network analyzer (2) to another antenna element of the waveguide antenna module (4),
wherein the vector network analyzer (2) is adapted to measure a transmission signal indicating the power transmitted from the first port (Port 1) of the vector network analyser (2) to the second port (Port 2) of the vector network analyser (2) while an antenna element of the multi-channel waveguide antenna module (4) is radiating electromagnetic waves being reflected back by a corner reflector (5) of the measurement apparatus (1),
wherein a time gating is applied to the measured transmission signal to isolate the signal reflection from the corner reflector (5) and to filter out unwanted reflections from surrounding surfaces, wherein the resulting frequency domain signal is processed by a processor of the vector network analyser (2) of the measurement apparatus (1) to provide performance parameters of the multi-channel waveguide antenna module (4).

15. The measurement apparatus according to claim 14 further comprising a rotary system (6) having a first rotary stage and a second rotary stage, wherein the waveguide antenna module (4) is mounted to plate of an adapter board (7), wherein the plate is rotated by a first rotary stage of the rotary system (6) of said measurement apparatus (1) around a surface normal of the plate to switch between an azimuth angle measurement with an adjustable azimuth angle and an elevation angle measurement with an adjustable elevation angle, and wherein the waveguide antenna module (4) is rotated by a second rotary stage of the rotary system (6) along with the vector network analyser (2).
